# EUROPEAN PATENT SPECIFICATION

(11) **EP 2 137 335 B1**
(45) Date of publication and mention of the grant of the patent: **12.02.2014**
(21) Application number: 08742472.7
(22) Date of filing: 02.04.2008
(51) Int. Cl.: C23C 14/24

(54) **FINE CONTROL OF VAPORIZED ORGANIC MATERIAL**
FEINSTEUERUNG EINES VERDAMPFTEN ORGANISCHEN MATERIALS
RÉGLAGE PRÉCIS DE MATIÈRE ORGANIQUE VAPORISÉE

(30) Priority: 16.04.2007 US 735544
(43) Date of publication of application: 30.12.2009
(73) Proprietor: Global OLED Technology LLC, Herndon, VA 20171 (US)
(72) Inventor: BOROSON, Michael Louis, Rochester, New York 14610 (US)
(74) Representative: Wibbelmann, Jobst
(86) International application number: PCT/US2008/004264
(87) International publication number: WO 2008/127554

(56) References cited:
- EP-A- 1 357 200
- US-A1- 2006 062 919

## Description

### FIELD OF THE INVENTION

The present invention relates to the field of physical vapor deposition where source materials are heated to a temperature to cause vaporization and create a vapor plume to form a thin film on a surface of a substrate.

### BACKGROUND OF THE INVENTION

An OLED device includes a substrate, an anode, a hole-transporting layer made of an organic compound, an organic luminescent layer with suitable dopants, an organic electron-transporting layer, and a cathode. OLED devices are attractive because of their low driving voltage, high luminance, wide-angle viewing and capability for full-color flat emission displays. Tang et al. have described this multilayer OLED device in U.S. Patents 4,769,292 and 4,885,211.

Physical vapor deposition in a vacuum environment is the principal means of depositing thin organic material films as used in small molecule OLED devices. Such methods are well known, for example Barr in U.S. 2,447,789 and Tanabe et al. in EP 0 982 411. The organic materials used in the manufacture of OLED devices are often subject to degradation when maintained at or near the desired rate dependant vaporization temperature for extended periods of time. Exposure of sensitive organic materials to higher temperatures can cause changes in the structure of the molecules and associated changes in material properties.

To overcome the thermal sensitivity of these materials, only small quantities of organic materials have been loaded in sources and they are heated as little as possible. In this manner, the material is consumed before it has reached the temperature exposure threshold to cause significant degradation. The limitations with this practice are that the available vaporization rate is very low due to the limitation on heater temperature, and the operation time of the source is very short due to the small quantity of material present in the source. It has been necessary to vent the deposition chamber, disassemble and clean the vapor source, refill the source, reestablish vacuum in the deposition chamber and degas the just-introduced organic material over several hours before resuming operation. The low deposition rate and the frequent and time consuming process associated with recharging a source has placed substantial limitations on the throughput of OLED manufacturing facilities.

A secondary consequence of heating the entire organic material charge to roughly the same temperature is that it is impractical to mix additional organic materials, such as dopants, with a host material unless the vaporization behavior and vapor pressure of the dopant is very close to that of the host material. This is generally not the case and as a result, such devices frequently require the use of separate sources to co-deposit host and dopant materials.

A consequence of using single component sources is that many sources are required in order to produce films containing a host and multiple dopants. These sources are arrayed one next to the other with the outer sources angled toward the center to approximate a co-deposition condition. In practice, the number of linear sources used to co-deposit different materials has been limited to three. This restriction has imposed a substantial limitation on the architecture of OLED devices, increases the necessary size and cost of the vacuum deposition chamber and decreases the reliability of the system. Additionally, the use of separate sources creates a gradient effect in the deposited film where the material in the source closest to the advancing substrate is overrepresented in the initial film immediately adjacent the substrate while the material in the last source is overrepresented in the final film surface.

A further limitation of such sources is that the geometry of the vapor manifold changes as the organic material charge is consumed. This change requires that the heater temperature change to maintain a constant vaporization rate. It is observed that the overall plume shape of the vapor exiting the orifices can change as a function of the organic material thickness and distribution in the source, particularly when the conductance to vapor flow in the source with a full charge of material is low enough to sustain pressure gradients from non-uniform vaporization within the source. In this case, as the material charge is consumed, the conductance increases and the pressure distribution and hence overall plume shape improve.

US Publication No. 2006/0062919 of Long et al., describes an apparatus that allows vaporization of organic materials at a predetermined rate over long periods of time without concomitant material degradation. However, it is difficult to use such an apparatus to make minor adjustment in vapor composition, for example, if the materials are off aim. To change the composition of the deposited material when using a single feeding apparatus with a mixture of materials would require emptying and refilling the apparatus. If using separate feeding apparatus for each component, it is difficult to accurately feed materials at vastly different rates. For example, to produce a deposited material that has 1% of a dopant in a host material would require a 99:1 ratio of feeding rates, which would be difficult to control accurately. Therefore, such apparatus can be difficult to use in manufacturing processes.

### SUMMARY OF THE INVENTION

It is therefore an object of the present invention to provide a method for vaporizing organic components to form a film on a substrate.

This object is achieved by a method for vaporizing organic components and delivering the vapor through opening(s) in a manifold to a substrate surface spaced from the manifold to form a film composed of the organic components, comprising:
a. delivering a first quantity of a single first organic component into a vaporization device where the component is vaporized and delivered at a first predetermined rate to the manifold;
b. delivering into a transport apparatus a quantity of a mixture of organic components in a predetermined ratio that includes the first organic component;
c. the transport apparatus delivering the mixture of organic components at a second predetermined rate to a flash heating region wherein the mixture is vaporized and delivered to the manifold; and
d. mixing the organic materials in the manifold, which permits the mixed vaporized components **221** to be deposited through the opening(s) onto the substrate surface to form the film.

### ADVANTAGES

It is an advantage of this invention that it provides a method of forming a film by vaporizing organic components wherein the composition of the film can easily be adjusted without stopping, emptying, and refilling the apparatus. It is a further advantage of this invention that the composition can be varied over a wide range without requiring large differences in the feed rates of the material in multiple transport apparatus. It is a further advantage of this invention that it can be applied to compositions of any number of components.

### BRIEF DESCRIPTION OF THE DRAWINGS

FIG. 1 is a three-dimensional view of one embodiment of an apparatus that can be used according to the present invention for vaporizing organic components and delivering the vapor to a substrate surface to form a film composed of the organic components;
FIG. 2 is a cross-sectional view of one embodiment of a portion of the above apparatus;
FIG. 3 shows a cross-sectional view of another apparatus that can be used according to the present invention for vaporizing organic components and delivering the vapor to a substrate surface to form a film composed of at least two organic components;
FIG. 4 shows a schematic of another apparatus that can be used according to the present invention for vaporizing organic components and delivering the vapor to a substrate surface to form a film composed of at least two organic components;
FIG. 5 shows a schematic of another apparatus that can be used according to the present invention for vaporizing organic components and delivering the vapor to a substrate surface to form a film composed of at least two organic components;
FIG. 6 is a block diagram showing one embodiment of the method of this invention;
FIG. 7 is a block diagram showing another embodiment of the method of this invention;
FIG. 8 is a block diagram showing another embodiment of the method of this invention;
FIG. 9 shows a three-component diagram of a range of compositions wherein three vaporization devices can be used; and
FIG. 10 is a cross-sectional view of an OLED device structure that can be prepared with the present invention.

### DETAILED DESCRIPTION OF THE INVENTION

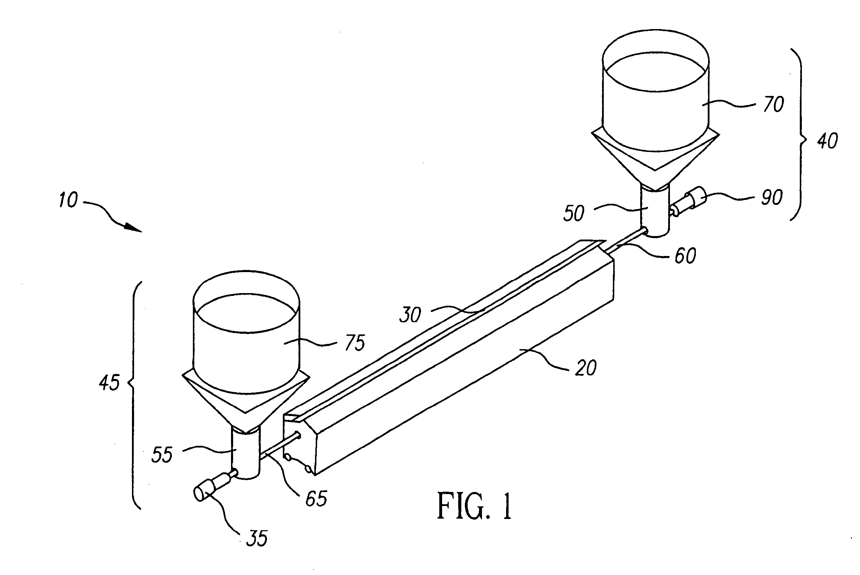

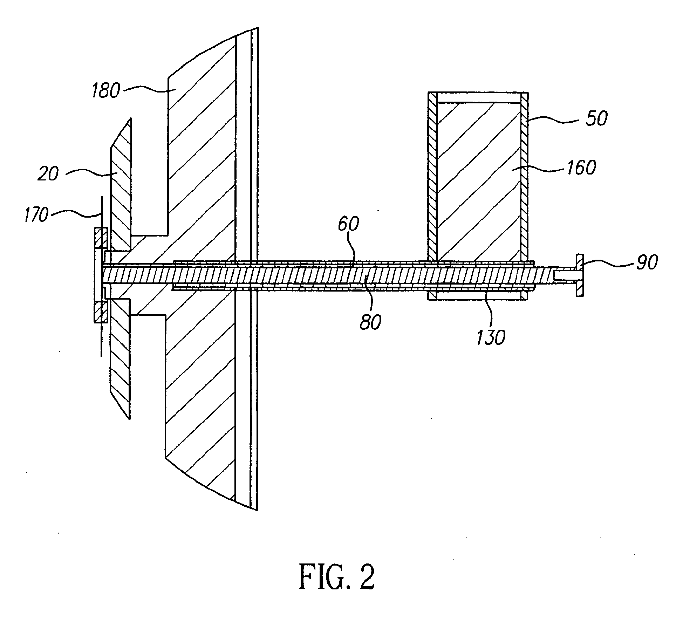

Turning now to FIG. 1, there is shown a three-dimensional view of one embodiment of an apparatus that can be used according to the present invention for vaporizing organic components and delivering the vapor to a substrate surface to form a film composed of at least two organic components. In US Publication No. 2006/0062919, by Long et al., the contents of which are incorporated herein by reference, have described vaporization apparatus 10. Vaporization apparatus **10** includes manifold **20,** attached first transport apparatus **40,** and attached second transport apparatus **45.** Transport apparatus **40** includes at least first container **50** and transport path **60.** Transport apparatus **45** includes at least second container **55** spaced from first container **50** and transport path **65.** A first quantity of a first organic material **160** as shown in FIG. 2, is delivered into first container **50** of transport apparatus **40.** A second quantity of a second organic material is delivered into second container **55** of second transport apparatus **45.** In one embodiment of this invention, the first organic material **160** is a single first organic component, and the second organic material is a mixture of organic components in a predetermined ratio that includes the first organic component. For the purposes of this discussion, a single organic material is an organic material that consists of substantially one component. Thus, an organic component that contains minor impurities that are not meant to be present, but are present due to the manufacturing process, will be considered a single organic component. One useful example of this embodiment is wherein the first organic component is a host material and the mixture of organic materials is a mixture of the host material and a dopant.

In another embodiment of this invention, the first organic material **160** is a first mixture of two or more organic components having a first predetermined ratio of the components, and the second organic material is a second mixture of two or more organic components that includes at least one organic component of the first mixture. The second mixture in this embodiment has a second predetermined ratio of organic components that is different from the first predetermined ratio. One example of this embodiment is where the first mixture is a mixture of a host and a dopant in a first predetermined ratio, and the second mixture is a mixture of the host and the dopant in a second, different predetermined ratio. Another example is wherein the first mixture is a mixture of a host and a dopant, and the second mixture is a mixture of the host and a co-host. Another example is wherein the first mixture is a mixture of a host and a co-host, and the second mixture is a mixture of the host, the co-host, and a dopant.

Transport apparatus **40** can also include third container **70,** and transport apparatus **45,** including motor **35** can include fourth container **75.** Third container **70** and fourth container **75** can function as reservoirs for first container **50** and second container **55,** respectively, as described by Long et al. Manifold **20** includes one or more openings **30** through which vaporized organic components can be delivered onto a substrate surface. Manifold **20** is shown in an orientation whereby it can form a layer on a horizontally oriented substrate, but it is not limited to this orientation. Manifold **20** can be oriented vertically and can form a layer on a vertical substrate. Transport apparatus **40** and transport apparatus **45** are shown attached to opposite sides of manifold **20,** but they can also be attached to the same side of manifold **20,** or to the bottom of manifold **20** if the manifold is in a vertical orientation. Manifold **20** can be an area manifold with a two-dimensional array of apertures, a linear manifold with a one-dimensional array of apertures, or a point manifold with a single aperture.

Turning now to FIG. 2, there is shown in further detail, a cross-sectional view of one embodiment of a portion of the above apparatus for transporting and vaporizing organic components. Transport apparatus **40** includes an auger **80** driven by a motor **90,** which delivers the first organic material **160** along transport path **60** into manifold **20** and heating element **170** at a predetermined rate. Heating element **170** can be for example, a heated screen and has been previously described in detail by Long et al. Transport apparatus **40** includes a flash heating region, which in this embodiment, is the region of transport path **60** immediately adjacent to heating element **170.** A thin cross-section of the organic material is rapidly heated to the temperature of heating element **170,** by virtue of contact and thermal conduction, whereby the thin cross-section of first organic material powder is vaporized and delivered to manifold **20.** The temperature of the flash heating region is selected as described in US Publication No. 2006/0062919, such that the organic material vaporizes rapidly and does not accumulate in the flash heating region. Auger **80** continuously meters the organic material to the flash heating region when vaporization of the organic material is desired, and can be turned off to stop vaporization when vaporization of the organic material is not desired. Similarly, second transport apparatus **45** of FIG. 1 delivers the corresponding second organic material to a corresponding second flash heating region at a second predetermined rate. The second organic material is vaporized in the second flash heating region and delivered to manifold **20.** The first and second vaporized organic materials are mixed in manifold **20,** and subsequently delivered to a substrate surface to form a film. The structure of transport apparatus **40** and the rotation rate of auger **80** control the rate at which organic material is delivered to heating element **170.** This linearly controls the rate of vaporization and therefore the rate at which organic material leaves the manifold in the vapor state. Thus a predetermined rate of delivering the organic material to the auger **80** and to the flash heating region controls the deposition rate of the vaporized organic material onto the desired surface to form a film. With two such structures, as in FIG.1, the relative predetermined rates of delivering the first and second organic materials to the respective augers and the respective flash heating regions controls the relative partial pressures of the first and second organic materials in the manifold, and hence their relative deposition rates and concentrations in the deposited film. The predetermined rates of delivering the first organic material **160** or the second organic material, or both, to their corresponding flash heating regions by the first or second transport apparatus can be changed to change the composition of the film.

By choosing the composition of the organic material, and by selecting the predetermined rates of delivery of the organic materials, it is possible to have fine control over the composition of the resulting film. If, for example, films are desired comprising 14-16% of a dopant in a host, one can use a first mixture of 10% dopant in the host, and a second mixture of 20% dopant in the host. One can then provide the two mixtures in a ratio of rates from 3:2 for a film of 14% dopant in host, to 2:3 for a film of 16% dopant in host. It is desirable to limit the ratio of the higher to the lower predetermined rates to less than 20:1 to provide good control. The embodiments herein comprise three or more individually vaporized organic materials. It is desirable that the ratio of the highest to the lowest of all predetermined rates be less than 20:1 on a weight or a volume basis. These conditions can be achieved by selecting the ratios of components in the mixtures of organic components.

Additionally, base **180** can be included to allow at least a portion of transport apparatus **40** to be temperature controlled. Base **180** is a heat-dissipating structure to prevent much of the heat produced by heating element **170** from traversing the length of transport path **60,** and thus keeps the bulk of the organic material significantly cooler than the conditions it experiences in the flash heating region immediately adjacent to heating element **170.** Heat dissipation by base **180** can include active cooling by well-known means, for example, by passing a cooling fluid through tubes or channels (not shown) in base **180.** Means of heat dissipation for base **180** have been described in U.S. Publication No. 2005/0186340 and in U.S. Publication No. 2006/0099345. A steep thermal gradient thereby created protects all but the immediately vaporizing material from the high temperatures.

When an organic material is a mixture of two or more different organic components, each one can have a different vaporization temperature. The temperature of heating element **170** is chosen such that the vaporization is delivery-rate limited, that is, the vapor pressure at the heating element temperature is substantially above the desired partial pressure of that component in the manifold, so that each of the organic components simultaneously vaporizes. The vaporization temperature can be determined by various means, as described in US Publication No. 2006/0062919.

It is further possible to provide more than two transport apparatus for delivering more than two mixtures of organic components to corresponding flash heating regions, and thus to the manifold and to the surface of the substrate.

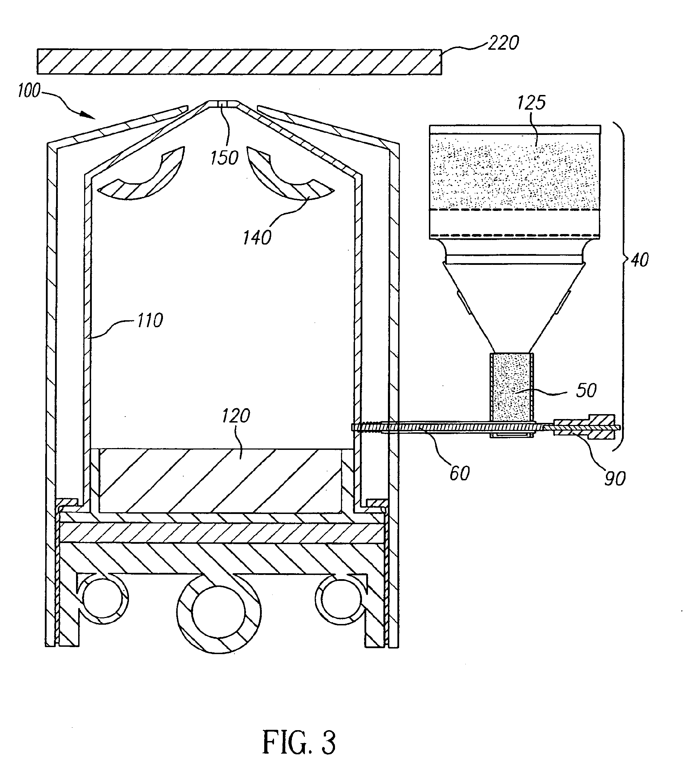

Turning now to FIG. 3, there is shown a cross-sectional view of another apparatus that can be used according to the present invention for vaporizing organic components and delivering the vapor to a substrate surface to form a film composed of at least two organic components. This apparatus can be used in the embodiment of this invention wherein a first organic material **120** is a single first organic component and a second organic material is a mixture of organic components that includes the first organic component. Vaporization apparatus **100** is a vaporization source that includes manifold **110** for containing vaporized organic components. Manifold **110** includes one or more openings **150** through which the vaporized organic material can be delivered for deposition onto the surface of substrate **220** spaced from manifold **110.** A quantity of single first organic component **120** is delivered to vaporization apparatus **100.** Vaporization apparatus **100** further includes a vaporization device, for example, one or more heating elements **140,** for example radiant heaters, to heat first organic component **120** above its vaporization temperature and deliver it to manifold **110** at a first predetermined rate. Vaporization apparatus **100** further includes a transport apparatus **40,** for example with an auger, as shown in other apparatus embodiments. A quantity of a mixture of organic components **125** in a predetermined ratio is delivered to transport apparatus **40,** which then delivers the mixture of organic components at a second predetermined rate to a flash heating region, for example, a permeable heating element as shown in other apparatus embodiments. Mixture of organic components **125** includes first organic component **120.** Mixture of organic components **125** is thus vaporized and delivered to manifold **110** at a predetermined rate. The vaporized organic components are mixed in manifold **110,** which permit the mixed vaporized components **221** to be deposited, through openings **150** of manifold **110,** onto the surface of substrate **220** to form a film. Changing the predetermined rates of vaporization of first organic component **120,** or that of mixture of organic components **125,** or both can change the composition of the film.

Other embodiments of this apparatus are possible. For example, first organic component **120** can be heated in a vaporization device such as a crucible or vaporization boat inside manifold **110** as well-known in the art. Vaporization apparatus **100** can include two or more vaporization devices such that at least two single organic components are vaporized and delivered at predetermined rates to manifold **110.** Vaporization apparatus **100** can include more than one transport apparatus **40** for delivering more than one mixture of organic components at predetermined rates to corresponding flash heating regions and thus to manifold **110.**

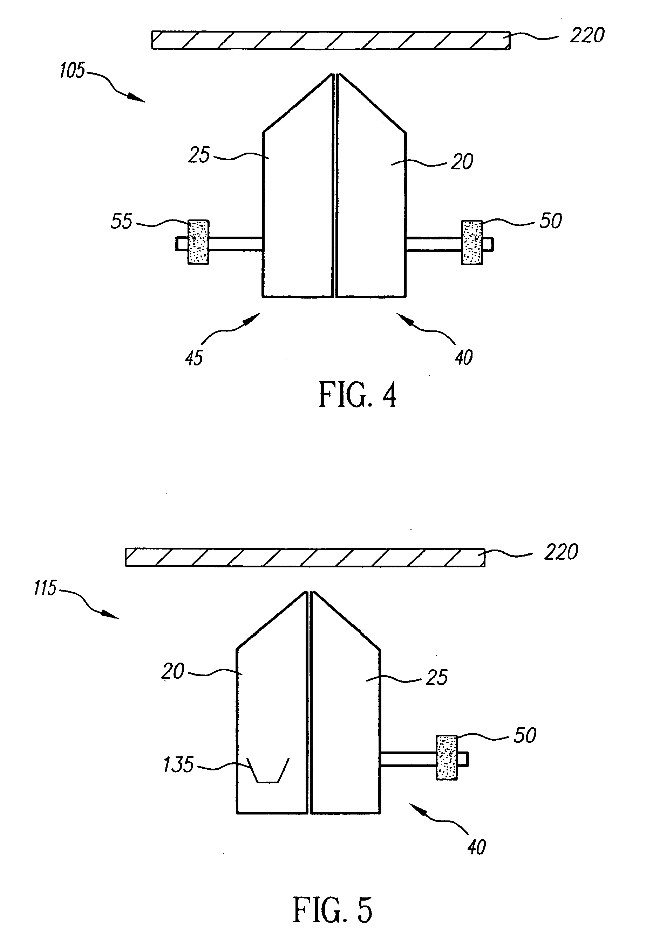

Turning now to FIG. 4, there is shown a schematic view of another apparatus that can be used according to the present invention for vaporizing organic components and delivering the vapor to a substrate surface to form a film composed of at least two organic components. Vaporization apparatus **105** serves the same function, and can be used in the same embodiments, as vaporization apparatus **10** in FIG. 1. However, vaporization apparatus **105** includes two manifolds, a first manifold **20** and a second manifold **25.** The first organic material **160** as described above, (for example, a single organic component or a mixture of organic components) is delivered by first transport apparatus **40** into first manifold **20.** The second organic material as described above, (for example, a mixture of organic components including at least one component from the first organic material **160** in a different concentration ratio) is delivered by second transport apparatus **45** into second manifold **25.** There is a corresponding flash heating region for each manifold as described above wherein the organic materials are vaporized into their corresponding manifolds. The vaporized components **221** are delivered through openings in the manifolds to the space between first and second manifolds **20** and **25** and substrate **220,** wherein the components are mixed, permitting the mixed organic components to be deposited onto the surface of substrate **220** to form a film.

Turning now to FIG. 5, there is shown a schematic view of another apparatus that can be used according to the present invention for vaporizing organic components and delivering the vapor to a substrate surface to form a film composed of at least two organic components. Vaporization apparatus **115** serves the same function, and can be used in the same embodiments, as vaporization apparatus **100** in FIG. 3. However, vaporization apparatus **115** includes two manifolds, a first manifold **20** and a second manifold **25.** The first organic component as described above is delivered into first manifold **20,** for example, into a vaporization device such as crucible **135,** where it can be heated and vaporized at a predetermined rate into first manifold **20,** and thus through openings to the space between first manifold **20** and substrate **220.** Transport apparatus 40 into second manifold 25 as described above delivers the mixture of organic components. There is a flash heating region for second manifold **25** as described above wherein the mixture of organic components is vaporized into second manifold **25.** The vaporized components **221** are delivered through openings in second manifold **25** to the space between the manifold and substrate **220.** The vaporized components **221** from both manifolds are mixed in the space between first and second manifolds **20** and **25** and substrate **220,** permitting the mixed organic components to be deposited onto the surface of substrate **220** to form a film.

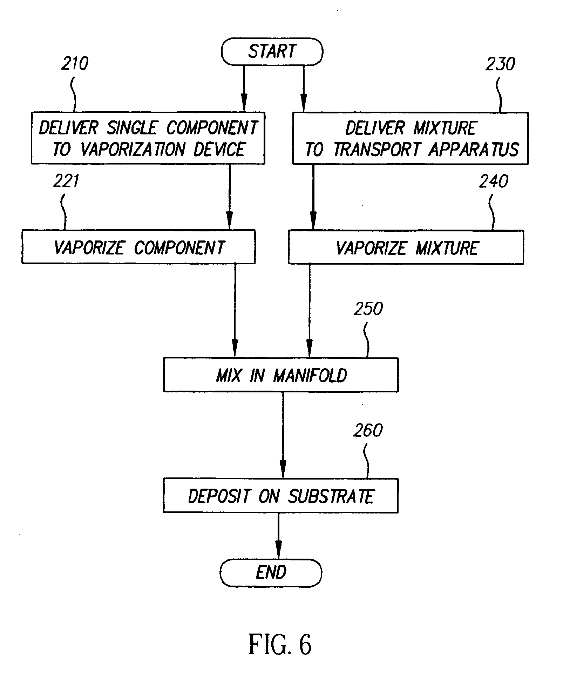

Turning now to FIG. 6, there is shown a block diagram showing one embodiment of the method of this invention for vaporizing organic components and delivering the vapor to a substrate surface to form a film. Initially, a single organic component is delivered to a vaporization device (Step **210**), where it is vaporized into the manifold (Step **220**). This can be accomplished by placing a charge of the component into the manifold and heating it (as in FIG. 3), or by delivering the component by a transport apparatus (as in FIG. 1). A mixture of organic components is delivered to a transport apparatus, as shown in FIG. 1 or FIG. 3 (Step **230**). The transport apparatus delivers the mixture to a flash heating region, where it is vaporized and delivered into the manifold (Step **240**). The components vaporized in Steps **220** and **240** mix in the manifold (Step **250**), and are delivered through openings in the manifold to a substrate, where the mixed components are deposited to form a film (Step **260**).

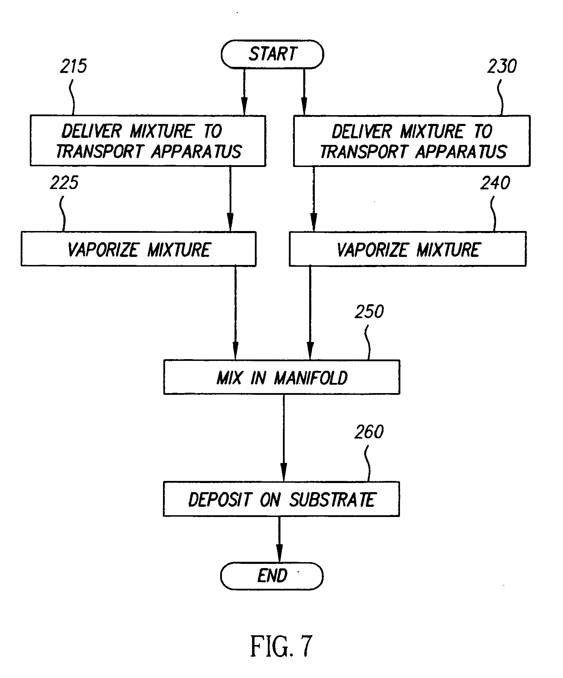

Turning now to FIG. 7, and referring to FIG. 1, there is shown a block diagram showing another embodiment of the method of this invention. A first mixture of organic components is delivered to a transport apparatus (Step **215**). The first transport apparatus delivers the mixture to a first flash heating region, where it is vaporized and delivered into the manifold (Step **225**). A second mixture of organic components is delivered to a second transport apparatus (Step **230**). The second transport apparatus delivers the mixture to a second flash heating region, where it is vaporized and delivered into the manifold (Step **240**). The components vaporized in Steps **225** and **240** mix in the manifold (Step **250**), and are delivered through openings in the manifold to a substrate, where the mixed components are deposited to form a film (Step **260**).

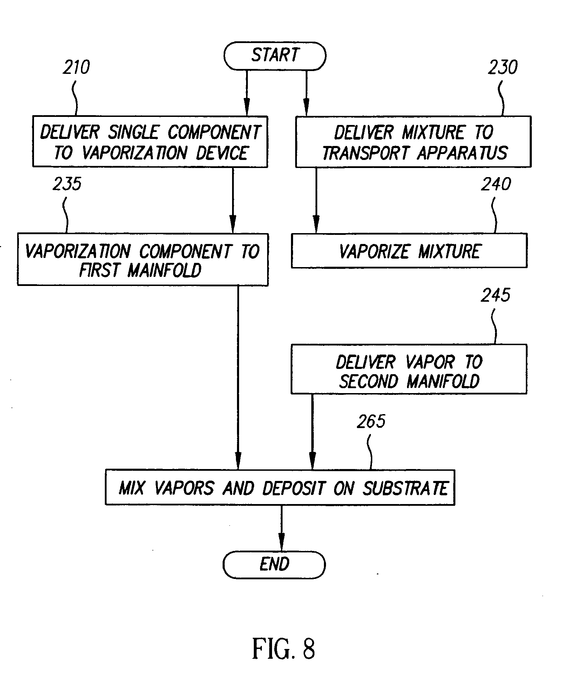

Turning now to FIG. 8, and referring to FIG. 5, there is shown a block diagram showing another embodiment of the method of this invention. Initially, a single organic component is delivered to a first manifold of a vaporization device (Step **210**), where it is vaporized into the manifold (Step **235**). A mixture of organic components is delivered to a transport apparatus (Step **230**). The transport apparatus delivers the mixture to a flash heating region (Step **240**), where it is vaporized and delivered into the second manifold (Step **245**). The vaporized components **221** in the manifolds are delivered through openings in their respective manifolds to the space between the manifolds and a substrate, where the components are mixed and deposited to form a film (Step **265**).

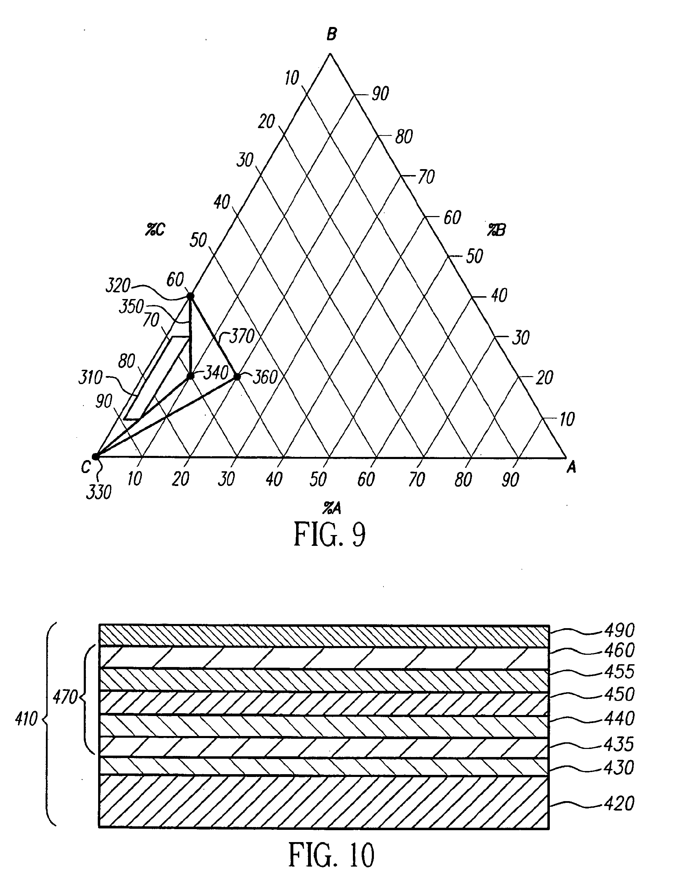

For films comprising more than two components, it can be necessary to have more than two vaporization devices or transport apparatus. In general, to control the concentration of all the components in a deposited film, the total number of vaporization devices and transport apparatus must be at least equal to the total number of components in the film. Turning now to FIG. 9, there is shown a three-component diagram of a range of compositions wherein three vaporization devices can be used. The three components shown are A, B, and C, which can represent for example, dopant, co-host, and host. Desired composition space **310** represents an example range of desired mixtures wherein A is from 1 to 5%, B is from 10 to 30%, and C is the remainder, that is, from 65 to 89% of the mixture. The use of three mixtures, for example, first mixture **320** comprising 40% B and 60% C, second mixture **330** comprising 100% C, and third mixture **340** comprising 10% A, 20% B, and 70% C, enclose the triangle shown as composition gamut **350,** which includes all of desired composition space **310.** The first, second, and third mixtures can be combined in different ratios to form any desired composition within composition gamut **350.** However, it is desirable to not have very disparate ratios of the mixtures. The ratio of any two components should not be greater than 20:1, as that would require metering one of the materials at a very low rate, leading to inconsistencies and inaccuracies. To produce a composition of 4.5% A, 30% B, and 65.5% C with the mixtures of FIG. 9 would require a ratio of first:second:third mixtures of 21:1:18. The first:second mixture ratio is greater than the desired 20:1 ratio. A more favorable result for all compositions within desired composition space **310** would be obtained if the third mixture comprised 20% A, 20% B, and 60% C, as with third mixture **360,** which provides a larger composition gamut **370.**

Turning now to FIG. 10, there is shown a cross-sectional view of a pixel of a light-emitting OLED device **410** that can be prepared in part according to the present invention. The OLED device **410** includes at a minimum a substrate **420,** a cathode **490,** an anode **430** spaced from cathode **490,** and a light-emitting layer **450.** The OLED device can also include a hole-injecting layer **435,** a hole-transporting layer **440,** an electron-transporting layer **455,** and an electron-injecting layer **460.** Hole-injecting layer **435,** hole-transporting layer **440,** light-emitting layer **450,** electron-transporting layer **455,** and electron-injecting layer **460** comprise a series of organic layers **470** disposed between anode **430** and cathode **490.** Organic layers **470** are the organic component films most desirably formed by the method of this invention. These components will be described in more detail.

Substrate **420** can be an organic solid, an inorganic solid, or a combination of organic and inorganic solids. Substrate **420** can be rigid or flexible and can be processed as separate individual pieces, such as sheets or wafers, or as a continuous roll. Typical substrate materials include glass, plastic, metal, ceramic, semiconductor, metal oxide, semiconductor oxide, semiconductor nitride, or combinations thereof. Substrate **420** can be a homogeneous mixture of materials, a composite of materials, or multiple layers of materials. Substrate **420** can be an OLED substrate, that is a substrate commonly used for preparing OLED devices, for example, active-matrix low-temperature polysilicon or amorphous-silicon TFT substrate. The substrate **420** can either be light transmissive or opaque, depending on the intended direction of light emission. The light transmissive property is desirable for viewing the EL emission through the substrate. Transparent glass or plastic are commonly employed in such cases. For applications where the EL emission is viewed through the top electrode, the transmissive characteristic of the bottom support is immaterial, and therefore can be light transmissive, light absorbing or light reflective. Substrates for use in this case include, but are not limited to, glass, plastic, semiconductor materials, ceramics, and circuit board materials, or any others commonly used in the formation of OLED devices, which can be either passive-matrix devices or active-matrix devices.

An electrode is formed over substrate **420** and is most commonly configured as an anode **430.** When EL emission is viewed through the substrate **420,** anode **430** should be transparent or substantially transparent to the emission of interest. Common transparent anode materials useful in this invention are indium-tin oxide and tin oxide, but other metal oxides can work including, but not limited to, aluminum- or indium-doped zinc oxide, magnesium-indium oxide, and nickel-tungsten oxide. In addition to these oxides, metal nitrides such as gallium nitride, metal selenides such as zinc selenide, and metal sulfides such as zinc sulfide, can be used as an anode material. For applications where EL emission is viewed through the top electrode, the transmissive characteristics of the anode material are immaterial and any conductive material can be used, transparent, opaque or reflective. Example conductors for this application include, but are not limited to, gold, iridium, molybdenum, palladium, and platinum. The preferred anode materials, transmissive or otherwise, have a work function of 4.1 eV or greater. Desired anode materials can be deposited by any suitable means such as evaporation, sputtering, chemical vapor deposition, or electrochemical means. Anode materials can be patterned using well-known photolithographic processes.

While not always necessary, it is often useful that a hole-injecting layer **435** be formed over anode **430** in an organic light-emitting display. The hole-injecting material can serve to improve the film formation property of subsequent organic layers and to facilitate injection of holes into the hole-transporting layer. Suitable materials for use in hole-injecting layer 435 include, but are not limited to, porphyrinic compounds as described in U.S. Patent 4,720,432, plasma-deposited fluorocarbon polymers as described in U.S. Patent 6,208,075, and inorganic oxides including vanadium oxide (VOx), molybdenum oxide (MoOx), nickel oxide (NiOx), Alternative hole-injecting materials reportedly useful in organic EL devices are described in EP 0 891 121 A1 and EP 1 029 909 A1.

While not always necessary, it is often useful that a hole-transporting layer **440** be formed and disposed over anode **430.** Desired hole-transporting materials can be deposited by any suitable means such as evaporation, sputtering, chemical vapor deposition, electrochemical means, thermal transfer, or laser thermal transfer from a donor material, and can be deposited by the method described herein. Hole-transporting materials useful in hole-transporting layer **440** are well known to include compounds such as an aromatic tertiary amine, where the latter is understood to be a compound containing at least one trivalent nitrogen atom that is bonded only to carbon atoms, at least one of which is a member of an aromatic ring. In one form the aromatic tertiary amine can be an arylamine, such as a monoarylamine, diarylamine, triarylamine, or a polymeric arylamine. U.S. Patent 3,180,730 illustrates exemplary monomeric triarylamines. Other suitable triarylamines substituted with one or in U.S. Patents 3,567,450 and 3,658,520, Brantley et al. disclose more vinyl radicals and comprises at least one active hydrogen-containing group..

In U.S. Patents 4,720,432 and 5,061,569, a more preferred class of aromatic tertiary amines are those which include at least two aromatic tertiary amine moieties as described. Such compounds include those represented by structural Formula A. 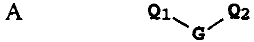 wherein:
Q₁ and Q₂ are independently selected aromatic tertiary amine moieties; and
G is a linking group such as an arylene, cycloalkylene, or alkylene group of a carbon to carbon bond.

In one embodiment, at least one of Q1 or Q2 contains a polycyclic fused ring structure, for example, a naphthalene. When G is an aryl group, it is conveniently a phenylene, biphenylene, or naphthalene moiety.

A useful class of triarylamines satisfying structural Formula A and containing two triarylamine moieties is represented by structural Formula B. 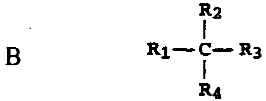 where:
R₁ and R₂ each independently represent a hydrogen atom, an aryl group, or an alkyl group or R₁ and R₂ together represent the atoms completing a cycloalkyl group; and
R₃ and R₄ each independently represent an aryl group, which is in turn substituted with a diaryl substituted amino group, as indicated by structural Formula C. 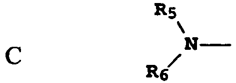 wherein R₅ and R₆ are independently selected aryl groups. In one embodiment, at least one of R₅ or R₆ contains a polycyclic fused ring structure, for example, a naphthalene.

Another class of aromatic tertiary amines are the tetraaryldiamines. Desirable tetraaryldiamines include two diarylamino groups, such as indicated by Formula C, and linked through an arylene group. Useful tetraaryldiamines includes those represented by Formula D. 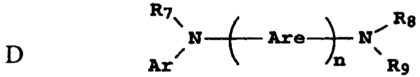 wherein:
each Are is an independently selected arylene group, such as a phenylene or anthracene moiety;
n is an integer of from I to 4; and
Ar, R₇, R₈, and R₉ are independently selected aryl groups.

In a typical embodiment, at least one of Ar, R₇, R₈, and R₉ is a polycyclic fused ring structure, for example, a naphthalene.

The various alkyl, alkylene, aryl, and arylene moieties of the foregoing structural Formulae A, B, C, D, can each in turn be substituted. Typical substituents include alkyl groups, alkoxy groups, aryl groups, aryloxy groups, and halogens such as fluoride, chloride, and bromide. The various alkyl and alkylene moieties typically contain from 1 to about 6 carbon atoms. The cycloalkyl moieties can contain from 3 to about 10 carbon atoms, but typically contain five, six, or seven carbon atoms--for example, cyclopentyl, cyclohexyl, and cycloheptyl ring structures. The aryl and arylene moieties are usually phenyl and phenylene moieties.

The hole-transporting layer in an OLED device can be formed of a single or a mixture of aromatic tertiary amine compounds. Specifically, one can employ a triarylamine, such as a triarylamine satisfying the Formula B, in combination with a tetraaryldiamine, such as indicated by Formula D. When a triarylamine is employed in combination with a tetraaryldiamine, the latter is positioned as a layer interposed between the triarylamine and the electron-injecting and transporting layer. The device and method described herein can be used to deposit single- or multi-component layers, and can be used to sequentially deposit multiple layers.

Another class of useful hole-transporting materials includes polycyclic aromatic compounds as described in EP 1 009 041. In addition, polymeric hole-transporting materials can be used such as poly(N-vinylcarbazole) (PVK), polythiophenes, polypyrrole, polyaniline, and copolymers such as poly(3,4-ethylenedioxythiophene)/poly(4-styrenesulfonate) also called PEDOT/PSS.

Light-emitting layer **450** produces light in response to hole-electron recombination. Light-emitting layer **450** is commonly disposed over hole-transporting layer **440.** Desired organic light-emitting materials can be deposited by any suitable means such as evaporation, sputtering, chemical vapor deposition, electrochemical means, or radiation thermal transfer from a donor material, and can be deposited by the method described herein. Useful organic light-emitting materials are well known. As more fully described in U.S. Patents 4,769,292 and 5,935,721, the light-emitting layers of the organic EL element comprise a luminescent or fluorescent material where electroluminescence is produced as a result of electron-hole pair recombination in this region. The light-emitting layers can be comprised of a single material, but more commonly include a host material doped with a guest compound or dopant where light emission comes primarily from the dopant. The dopant is selected to produce color light having a particular spectrum. The host materials in the light-emitting layers can be an electron-transporting material, as defined below, a hole-transporting material, as defined above, or another material that supports hole-electron recombination. The dopant is usually chosen from highly fluorescent dyes, but phosphorescent compounds; for example, transition metal complexes as described in WO 98/55561, WO 00/18851, WO 00/57676, and WO 00/70655 are also useful. Dopants are typically coated as 0.01 to 10 % by weight into the host material. Further, a second host material, or co-host, can be used. The method described herein can be used to coat multi-component guest/host layers without the need for multiple vaporization sources.

Host and emitting molecules known to be of use include, but are not limited to, those disclosed in U.S. Patents 4,768,292; 5,141,671; 5,150,006; 5,151,629; 5,294,870; 5,405,709; 5,484,922; 5,593,788; 5,645,948; 5,683,823; 5,755,999; 5,928,802; 5,935,720; 5,935,721; and 6,020,078.

Metal complexes of 8-hydroxyquinoline and similar derivatives (Formula E) constitute one class of useful host materials capable of supporting electroluminescence, and are particularly suitable for light emission of wavelengths longer than 500 nm, for example, green, yellow, orange, and red. 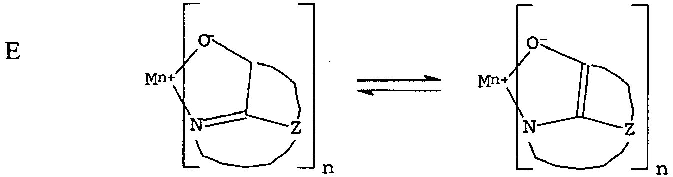 wherein:
M represents a metal;
n is an integer of from 1 to 3; and
Z independently in each occurrence represents the atoms completing a nucleus having at least two fused aromatic rings.

From the foregoing it is apparent that the metal can be a monovalent, divalent, or trivalent metal. The metal can, for example, be an alkali metal, such as lithium, sodium, or potassium; an alkaline earth metal, such as magnesium or calcium; or an earth metal, such as boron or aluminum. Generally any monovalent, divalent, or trivalent metal known to be a useful chelating metal can be employed.

Z completes a heterocyclic nucleus containing at least two fused aromatic rings, at least one of which is an azole or azine ring. Additional rings, including both aliphatic and aromatic rings, can be fused with the two required rings, if required. To avoid adding molecular bulk without improving on function the number of ring atoms is usually maintained at 18 or less.

The host material in light-emitting layer **450** can be an anthracene derivative having hydrocarbon or substituted hydrocarbon substituents at the 9 and 10 positions. For example, derivatives of 9,10-di-(2-naphthyl)anthracene constitute one class of useful host materials capable of supporting electroluminescence, and are particularly suitable for light emission of wavelengths longer than 400 nm, for example, blue, green, yellow, orange or red.

Benzazole derivatives constitute another class of useful host materials capable of supporting electroluminescence, and are particularly suitable for light emission of wavelengths longer than 400 nm, for example, blue, green, yellow, orange or red. An example of a useful benzazole is 2, 2', 2"-(1,3,5-phenylene)tris[1-phenyl-1H-benzimidazole].

Desirable fluorescent dopants include perylene or derivatives of perylene, derivatives of anthracene, tetracene, xanthene, rubrene, coumarin, rhodamine, quinacridone, dicyanomethylenepyran compounds, thiopyran compounds, polymethine compounds, pyrilium and thiapyrilium compounds, derivatives of distryrylbenzene or distyrylbiphenyl, bis(azinyl)methane boron complex compounds, and carbostyryl compounds.

Other organic emissive materials can be polymeric substances, for example, polyphenylenevinylene derivatives, dialkoxy-polyphenylenevinylenes, poly-para-phenylene derivatives, and polyfluorene derivatives, as taught by Wolk et al. in commonly assigned U.S. Patent 6,194,119 B1 and references cited therein.

While not always necessary, it is often useful that OLED device **410** includes an electron-transporting layer **455** disposed over light-emitting layer **450.** Desired electron-transporting materials can be deposited by any suitable means such as evaporation, sputtering, chemical vapor deposition, electrochemical means, thermal transfer, or laser thermal transfer from a donor material, and can be deposited by the method described herein. Preferred electron-transporting materials for use in electron-transporting layer **455** are metal chelated oxinoid compounds, including chelates of oxine itself (also commonly referred to as 8-quinolinol or 8-hydroxyquinoline). Such compounds help to inject and transport electrons and exhibit both high levels of performance and are readily fabricated in the form of thin films. Exemplary of contemplated oxinoid compounds are those satisfying structural Formula E, previously described.

Other electron-transporting materials include various butadiene derivatives as disclosed in U.S. Patent 4,356,429 and various heterocyclic optical brighteners as described in U.S. Patent 4,539,507. Benzazoles satisfying structural Formula G are also useful electron-transporting materials.

Other electron-transporting materials can be polymeric substances, for example, polyphenylenevinylene derivatives, poly-para-phenylene derivatives, polyfluorene derivatives, polythiophenes, polyacetylenes, and other conductive polymeric organic materials such as those listed in Handbook of Conductive Molecules and Polymers, Vols. 1-4, H.S. Nalwa, ed., John Wiley and Sons, Chichester (1997).

An electron-injecting layer **460** can also be present between the cathode and the electron-transporting layer. Examples of electron-injecting materials include alkaline or alkaline earth metals, alkali halide salts, such as LiF mentioned above, or alkaline or alkaline earth metal doped organic layers.

Cathode **490** is formed over the electron-transporting layer **455** or over light-emitting layer **450** if an electron-transporting layer is not used. When light emission is through the anode **430,** the cathode material can be comprised of nearly any conductive material. Desirable materials have good film-forming properties to ensure good contact with the underlying organic layer, promote electron injection at low voltage, and have good stability. Useful cathode materials often contain a low work function metal (< 3.0 eV) or metal alloy. One preferred cathode material is comprised of a Mg:Ag alloy wherein the percentage of silver is in the range of 1 to 20 %, as described in U.S. Patent 4,885,221. Another suitable class of cathode materials includes bilayers comprised of a thin layer of a low work function metal or metal salt capped with a thicker layer of conductive metal. One such cathode is comprised of a thin layer of LiF followed by a thicker layer of A1 as described in U.S. Patent 5,677,572. Other useful cathode materials include, but are not limited to, those disclosed in U.S. Patents 5,059,861; 5,059,862; and 6,140,763.

When light emission is viewed through cathode **490,** it must be transparent or nearly transparent. For such applications, metals must be thin or one must use transparent conductive oxides, or a combination of these materials. Optically transparent cathodes have been described in more detail in U.S. Patent 5,776,623. Evaporation, sputtering, or chemical vapor deposition can deposit cathode materials. When needed, patterning can be achieved through many well known methods including, but not limited to, through-mask deposition, integral shadow masking as described in U.S. Patent 5,276,380 and EP 0 732 868, laser ablation, and selective chemical vapor deposition.

The invention has been described in detail with particular reference to certain preferred embodiments thereof, but it will be understood that variations and modifications can be effected within the spirit and scope of the invention.

### PARTS LIST

- 10: vaporization apparatus
- 20: manifold
- 25: manifold
- 30: opening
- 35: motor
- 40: first transport apparatus
- 45: second transport apparatus
- 50: first container
- 55: second container
- 60: transport path
- 65: transport path
- 70: third container
- 75: fourth container
- 80: auger
- 90: motor
- 100: vaporization apparatus
- 105: vaporization apparatus
- 110: manifold
- 115: vaporization apparatus
- 120: first organic component
- 125: mixture of organic components
- 135: crucible
- 140: heating element
- 150: opening
- 160: first organic material
- 170: heating element
- 180: base
- 210: step
- 215: step
- 220: substrate
- 221: step
- 225: step
- 230: step
- 235: step
- 240: step
- 245: step
- 250: step
- 260: step
- 265: step
- 310: desired composition space
- 320: first mixture
- 330: second mixture
- 340: third mixture
- 350: composition gamut
- 360: third mixture
- 370: composition gamut
- 410: OLED device
- 420: substrate
- 430: anode
- 435: hole-injecting layer
- 440: hole-transporting layer
- 450: light-emitting layer
- 455: electron-transporting layer
- 460: electron-injecting layer
- 470: organic layers
- 490: cathode

## Claims

1. A method for vaporizing organic components and delivering the vapor through opening(s) in a manifold to a substrate surface spaced from the manifold to form a film composed of at least two organic components, comprising:
a. delivering a first quantity of a single first organic component into a vaporization device where the component is vaporized and delivered at a first predetermined rate to the manifold;
b. delivering into a transport apparatus a quantity of a mixture of organic components in a predetermined ratio that includes the first organic component;
c. the transport apparatus delivering the mixture of organic components at a second predetermined rate to a flash heating region wherein the mixture is vaporized and delivered to the manifold; and
d. mixing the mixed organic components in the manifold, which permits the mixed vaporized components to be deposited through the opening(s) onto the substrate surface to form the film.

2. The method according to claim 1 further including changing the predetermined rate(s) of the first organic component or the mixture of organic components or both delivered to the manifold to change the composition of the film.

3. The method according to claim 1 further including limiting the ratio of the higher to the lower of the first and second predetermined rates to less than 20:1.

4. The method of claim 1 wherein the mixture of organic components includes a host and a dopant.

5. The method of claim 1 wherein the transport apparatus includes an auger.

6. The method of claim 5 wherein the auger continuously meters the mixture to the flash heating region when vaporization of the mixture is desired and is off only when vaporization of the mixture is not desired.

7. The method of claim 1 wherein at least a portion of the transport apparatus is cooled.

8. The method of claim 1 further comprising providing more than one transport apparatus for delivering more than one mixture of organic components at predetermined rates to corresponding flash heating regions.

9. The method according to claim 8 further including limiting the ratio of the highest to the lowest of the predetermined rates to less than 20:1.

10. The method of claim 8 wherein a first mixture includes a host and dopant and a second mixture includes a host and co-host.

11. The method of claim 8 wherein a first mixture is a mixture of a host and co-host and a second mixture is a mixture of a host, co-host, and dopant.

12. The method of claim 8 wherein the total number of transport apparatus and vaporization devices is equal to or greater than the total number of components in the film.

13. The method of claim 1 further comprising providing at least two vaporization devices wherein at least two single organic components are vaporized and delivered at predetermined rates to the manifold.

14. The method according to claim 13 further including limiting the ratio of the highest to the lowest of the predetermined rates to less than 20:1.

15. A method for vaporizing a mixture of organic components and delivering the vapor through opening(s) in a manifold to a substrate surface spaced from the manifold to form a film, comprising:
a. delivering into a first transport apparatus a first quantity of a first mixture of the organic components having a first predetermined ratio;
b. delivering into a second transport apparatus a second quantity of a second mixture of the organic components that includes at least one organic component of the first mixture and has a second predetermined ratio that is different than the first predetermined ratio;
c. the first and second transport apparatus delivering their corresponding mixtures in predetermined rates to corresponding first and second flash heating regions where the mixtures are vaporized and delivered to the manifold; and
d. mixing the first and second mixtures in the manifold, which permits the mixed vaporized components to be deposited through the opening(s) onto the substrate surface to form the film.

## Patentansprüche

1. Verfahren zum Verdampfen von organischen Komponenten und Liefern des Dampfs durch Öffnung(en) in einem Verteiler auf eine Substratoberfläche, die von dem Verteiler beabstandet ist, um einen Film zu bilden, der aus mindestens zwei organischen Komponenten zusammengesetzt ist, umfassend:
a. Liefern einer ersten Menge einer einzelnen ersten organischen Komponente in eine Verdampfungsvorrichtung, wo die Komponente verdampft wird und mit einer ersten vorbestimmten Geschwindigkeit an den Verteiler geliefert wird;
b. Liefern einer Menge einer Mischung von organischen Komponenten in einem vorbestimmten Verhältnis, welche die erste organische Komponente einschließt, in eine Transportvorrichtung;
c. wobei die Transportvorrichtung die Mischung von organischen Komponenten mit einer zweiten vorbestimmten Geschwindigkeit zu einem Flash-Heizbereich liefert, in dem die Mischung verdampft wird und an den Verteiler geliefert wird; und
d. Mischen der gemischten organischen Komponenten in dem Verteiler, was ermöglicht, dass die gemischten verdampften Komponenten durch die Öffnung(en) unter Bildung des Films auf der Substratoberfläche abgeschieden werden.

2. Verfahren nach Anspruch 1, ferner einschließend die Änderung der vorbestimmten Geschwindigkeit(en) der ersten organischen Komponente oder der Mischung von organischen Komponenten oder von beiden, die an den Verteiler geliefert werden, um die Zusammensetzung des Films zu ändern.

3. Verfahren nach Anspruch 1, ferner einschließend die Begrenzung des Verhältnisses der höheren zu der niedrigeren der ersten und zweiten vorbestimmten Geschwindigkeiten auf weniger als 20:1.

4. Verfahren nach Anspruch 1, bei dem die Mischung von organischen Komponenten mindestens einen Wirt und ein Dotiermittel einschließt.

5. Verfahren nach Anspruch 1, bei dem die Transportvorrichtung einen Schneckenförderer einschließt.

6. Verfahren nach Anspruch 5, bei dem der Schneckenförderer kontinuierlich die Mischung zu dem Flash-Heizbereich dosiert, wenn die Verdampfung der Mischung gewünscht wird, und nur abgeschaltet ist, wenn die Verdampfung der Mischung nicht gewünscht wird.

7. Verfahren nach Anspruch 1, bei dem zumindest ein Teil der Transportvorrichtung gekühlt wird.

8. Verfahren nach Anspruch 1, weiter umfassend das Vorsehen von mehr als einer Transportvorrichtung zur Zufuhr von mehr als einer Mischung von organischen Komponenten mit vorbestimmten Geschwindigkeiten zu entsprechenden Flash-Heizbereichen.

9. Verfahren nach Anspruch 8, ferner einschließend die Begrenzung des Verhältnisses der höchsten zu der niedrigsten von den vorbestimmten Geschwindigkeiten auf weniger als 20:1.

10. Verfahren nach Anspruch 8, bei dem eine erste Mischung einen Wirt und ein Dotiermittel einschließt und eine zweite Mischung einen Wirt und einen Co-Wirt einschließt.

11. Verfahren nach Anspruch 8, bei dem eine erste Mischung eine Mischung eines Wirts und eines Co-Wirts ist und eine zweite Mischung eine Mischung eines Wirts, eines Co-Wirts und eines Dotiermittels ist.

12. Verfahren nach Anspruch 8, bei dem die Gesamtzahl von Transportvorrichtung und Verdampfungsvorrichtungen gleich oder größer ist als die Gesamtzahl der Komponenten in dem Film.

13. Verfahren nach Anspruch 1, weiter umfassend das Vorsehen von mindestens zwei Verdampfungsvorrichtungen, in denen mindestens zwei einzelne organische Komponenten verdampft und mit vorbestimmten Geschwindigkeiten zu dem Verteiler geliefert werden.

14. Verfahren nach Anspruch 13, ferner einschließend die Begrenzung des Verhältnisses der höchsten zu der niedrigsten der vorbestimmten Geschwindigkeiten auf weniger als 20:1.

15. Verfahren zum Verdampfen einer Mischung von organischen Komponenten und Liefern des Dampfes durch Öffnung(en) in einem Verteiler zu einer Substratoberfläche, die von dem Verteiler beabstandet ist, um einen Film zu bilden, umfassend:
a. Liefern einer ersten Menge einer ersten Mischung der organischen Komponenten, die ein erstes vorbestimmtes Verhältnis aufweisen, in eine erste Transportvorrichtung;
b. Liefern einer zweiten Menge einer zweiten Mischung der organischen Komponenten, die mindestens eine organische Komponente der ersten Mischung einschließt und ein zweites vorbestimmtes Verhältnis aufweist, das von dem ersten vorbestimmten Verhältnis verschieden ist, in eine zweite Transportvorrichtung;
c. wobei die erste und zweite Transportvorrichtung ihre entsprechenden Mischungen in vorbestimmten Verhältnissen an entsprechende erste und zweite Flash-Heizbereiche liefern, wo die Mischungen verdampft und an den Verteiler geliefert werden; und
d. Mischen der ersten und zweiten Mischungen in dem Verteiler, was ermöglicht, dass die gemischten verdampften Komponenten durch die Öffnung(en) unter Bildung des Films auf der Substratoberfläche abgeschieden werden.

## Revendications

1. Procédé de vaporisation de composants organiques et de délivrance de la vapeur à travers une/des ouverture(s) dans un collecteur jusqu'à une surface de substrat espacée du collecteur afin de former un film composé d'au moins deux composants organiques, comprenant :
a. la délivrance d'une première quantité d'un premier composant organique unique dans un dispositif de vaporisation où le composant est vaporisé et délivré à un premier débit prédéterminé jusqu'au collecteur ;
b. la délivrance dans un appareil de transport d'une quantité d'un mélange de composants organiques à un rapport prédéterminé qui inclut le premier composant organique ;
c. l'appareil de transport délivrant le mélange de composants organiques à un deuxième débit prédéterminé jusqu'à une région de chauffage éclair dans laquelle le mélange est vaporisé et délivré jusqu'au collecteur ; et
d. le mélange des composants organiques mélangés dans le collecteur, ce qui permet que les composants vaporisés mélangés soient déposés à travers la/les ouverture(s) sur la surface de substrat afin de former le film.

2. Procédé selon la revendication 1, incluant en outre le changement du/des débit(s) prédéterminé(s) du premier composant organique ou du mélange de composants organiques ou des deux délivré(s) jusqu'au collecteur afin de changer la composition du film.

3. Procédé selon la revendication 1, incluant en outre la limitation du rapport du plus haut sur le plus bas des premier et deuxième débits prédéterminés à moins de 20:1.

4. Procédé selon la revendication 1, dans lequel le mélange de composants organiques inclut un hôte et un dopant.

5. Procédé selon la revendication 1, dans lequel l'appareil de transport inclut une vis sans fin.

6. Procédé selon la revendication 5, dans lequel la vis sans fin mesure en continu le mélange jusqu'à la région de chauffage éclair lorsqu'une vaporisation du mélange est désirée et n'est désactivée que lorsqu'une vaporisation du mélange n'est pas désirée.

7. Procédé selon la revendication 1, dans lequel au moins une partie de l'appareil de transport est refroidie.

8. Procédé selon la revendication 1, comprenant en outre la prévision de plus d'un appareil de transport pour délivrer plus d'un mélange de composants organiques à des débits prédéterminés jusqu'à des régions de chauffage éclair correspondantes.

9. Procédé selon la revendication 8, incluant en outre la limitation du rapport du plus haut sur le plus bas des débits prédéterminés à moins de 20:1.

10. Procédé selon la revendication 8, dans lequel un premier mélange inclut un hôte et un dopant et un deuxième mélange inclut un hôte et un co-hôte.

11. Procédé selon la revendication 8, dans lequel un premier mélange est un mélange d'un hôte et d'un co-hôte et un deuxième mélange est un mélange d'un hôte, d'un co-hôte, et d'un dopant.

12. Procédé selon la revendication 8, dans lequel le nombre total d'appareils de transport et de dispositifs de vaporisation est égal ou supérieur au nombre total de composants dans le film.

13. Procédé selon la revendication 1, comprenant en outre la prévision d'au moins deux dispositifs de vaporisation dans lesquels au moins deux composants organiques uniques sont vaporisés et délivrés à des débits prédéterminés jusqu'au collecteur.

14. Procédé selon la revendication 13, incluant en outre la limitation du rapport du plus haut sur le plus bas des débits prédéterminés à moins de 20:1.

15. Procédé de vaporisation d'un mélange de composants organiques et de délivrance de la vapeur à travers une/des ouverture(s) dans un collecteur jusqu'à une surface de substrat espacée du collecteur afin de former un film, comprenant :
a. la délivrance dans un premier appareil de transport d'une première quantité d'un premier mélange des composants organiques ayant un premier rapport prédéterminé ;
b. la délivrance dans un deuxième appareil de transport d'une deuxième quantité d'un deuxième mélange des composants organiques qui inclut au moins un composant organique du premier mélange et a un deuxième rapport prédéterminé qui est différent du premier rapport prédéterminé ;
c. le premier et le deuxième appareils de transport délivrant leurs mélanges correspondants à des débits prédéterminés jusqu'à des première et deuxième régions de chauffage éclair correspondantes où les mélanges sont vaporisés et délivrés jusqu'au collecteur ; et
d. le mélange des premier et deuxième mélanges dans le collecteur, ce qui permet que les composants vaporisés mélangés soient déposés à travers la/les ouverture(s) sur la surface de substrat afin de former le film.
